# EUROPEAN PATENT SPECIFICATION

(11) **EP 2 444 149 B1**
(45) Date of publication and mention of the grant of the patent: **13.01.2016**
(21) Application number: 10789547.6
(22) Date of filing: 17.06.2010
(51) Int. Cl.: B01J 19/00, B81B 1/00, B81C 3/00, C03C 27/06, G01N 37/00

(54) **MANUFACTURING METHOD FOR SMALL-SIZED REACTORS**
VERFAHREN ZUR HERSTELLUNG KLEINFLÄCHIGER REAKTOREN
PROCÉDÉ DE FABRICATION POUR DES RÉACTEURS DE PETITE TAILLE

(30) Priority: 19.06.2009 JP 2009147078
(43) Date of publication of application: 25.04.2012
(73) Proprietor: Dexerials Corporation, Tokyo (JP)
(72) Inventor: KANEKO, Yuji, Kanuma-shi Tochigi 322-8503 (JP); ENDO, Katsunobu, Kanuma-shi Tochigi 322-8503 (JP); SAKAKIBARA, Shigeshi, Tome-shi Miyagi 987-0622 (JP); SHINODA, Kazuhiro, Tome-shi Miyagi 987-0622 (JP)
(74) Representative: Müller Hoffmann & Partner
(86) International application number: PCT/JP2010/060271
(87) International publication number: WO 2010/147173

(56) References cited:
- JP-A- 7 220 923
- JP-A- 2003 054 971
- JP-A- 2003 084 130
- JP-A- 2004 256 380
- US-A1- 2004 109 793
- US-B1- 6 167 910
- US-B1- 6 284 085

## Description

### Technical Field

This invention relates to a technical field of a small-sized reactor and, more particularly, to a method for producing a small-sized reactor, which is excellent for practical purposes, and to the small-sized reactor.

The present application asserts priority rights based on JP Patent Application 2009-147078 filed on June 19, 2009.

### Background Art

US 6,284,085 B2 describes a bonding method for bonding two silicate surfaces to each other through siloxane bridges. The bonding process uses a hydroxid bonding material, to which a silicate material can be added to compensate for surface roughness.

US 6,167,910 B2 describes a multilayer microfluidic device based on a plurality of stacked substrates. In each substrate a plurality of ports and a plurality of grooves form channel networks, wherein the channel networks are in fluid communication with the ports. Silica-based substrates are bonded to each other by standard bond methods such as direct bonding.

US 2004/0109793 A1 describes a three dimensional micro fluidic device formed from a plurality of substantially planar layers. The planar layers include micro fluidic channels and wells and are held together by a clamp that includes a top frame and a bottom frame aligned to each other by alignment holes and alignment rods. The alignment rods are spring loaded to apply compressive force to hold the layers of the device together.

Up to now, researches and developments in chemical synthesis or reactions were carried out using commonplace test equipment, such as a beaker or a flask. However, with the beakers, non-homogeneous mixing of reagents or temperature variations tends to occur to generate by-products. Or, explosive thermal reactions may take place to render experiments uncontrollable.

These defects may take place in similar manner in plant-level chemical synthesis, such that, with increase in the volume of reactants, bi-products are generated in increasing amounts.

Recently, attempts are initiated to overcome the above mentioned defects using a micro-reactor (small-sized reactor) capable of carrying out a reaction at minimum units in amounts or lengths.

The micro-reactor is a reaction device that allows carrying out a chemical reaction in an extremely small space, and is recently stirring up notice because of high operational efficiency and high safety. The chemical synthesis, employing the micro-reactor, may be automated by computer control, whilst a large number of reactions under varying conditions may readily be carried out in succession. It is thus probable that the manner of carrying out chemical processes is thereby changed radically.

Nowadays, a micro-reactor comprised of a plurality of stainless steel (SUS) sheets, bonded together, represents a mainstream. However, an SUS sheet is weak against acids and alkalis and hence a micro-reactor formed of SUS may not be used for a reaction employing these as reagents.

On the other hand, a liquid drug flowing in the micro-reactor formed of SUS or the reaction taking place in such micro-reactor is not visible and hence the state of progress of the reaction process may not be visually checked from outside. In addition, should the liquid drug stop-up occur in the inside of the micro-reactor, proper measures may not be taken because the inside of the micro-reactor may not be seen from outside.

Hence, there is a need felt for a micro-reactor employing a glass plate or a quartz-glass plate strong against acids or alkalis.

However, if the micro-reactor is formed by layering a plurality of glass plates by bonding them together with an adhesive, components dissolved from the adhesive tend to be mixed as impurities into the chemical reaction system during use of the micro-reactor. These impurities may not be discounted because it is the reagents of extremely small amounts that make up a reaction system.

On the other hand, if the micro-reactor is fabricated using an adhesive, the internal pressure in the fluid duct may not be raised due to the low bonding strength or to the low upper limit working temperature, whilst a high reaction temperature also may not be used.

The micro-reactor of the related technique has been shown in, for example, the following document.

### Related Technical Documents

### Patent Documents

Patent Document 1:
   Japanese Laid-Open Patent Publication 2005-66382
Patent Document 2:
   Japanese Laid-Open Patent Publication 2004-81949

### Summary of the Invention

### Problem to be solved by the Invention

The present invention has been made to obviate the above mentioned inconveniences of the related technique. It is an object of the present invention to provide a small-sized reactor excellent in practical use performance from the standpoint of high bonding strength, observation of the inner state, exemption from impurities and a high pressure withstanding characteristic.

### Means for solving the Problem

To obviate the above problem, the present invention provides a method for producing a small-sized reactor made up of a plurality of inorganic transparent substrates, each having a surface(s) for bonding, in which the inorganic transparent substrates are bonded together, with the surfaces for bonding in tight contact with each other, to define an inner flow duct for a fluid therein. The method includes polishing the surface(s) for bonding of each of the inorganic transparent substrates so that a centerline average roughness Ra will be not greater than 2 nm, and machining a part of an area of the surface(s) for bonding of each of the inorganic transparent substrates to form a groove. The method also includes hydrophilicity enhancing the surface(s) for bonding of each of the inorganic transparent substrates and subsequently allowing the surfaces for bonding to be contacted with water. The method also includes removing water contacted with the surfaces for bonding following the hydrophilicity enhancing processing under centrifugal force caused by rotation of each of the inorganic transparent substrates. The method further includes heating, as the surfaces for bonding of the inorganic transparent substrates are contacted with one another, each of the inorganic transparent substrates to a preset bonding temperature to bond the inorganic transparent substrates to one another.

The present invention also provides a method for producing the small-sized reactor in which each of the inorganic transparent substrates is formed of glass, with the temperature of the heating being not less than 500°C and not higher than 1000°C.

The present invention also provides a method for producing the small-sized reactor, in which the inside of the flow duct is heated to the temperature for heating as the inside of the flow duct is exposed to outside the small-sized reactor.

The present invention also provides a method for producing the small-sized reactor in which the hydrophilicity enhancing processing is carried out as each of the surfaces for bonding is contacted with a hydrophilicity enhancing solution containing aqueous hydrogen peroxide and ammonia.

The present invention also provides a method for producing a small-sized reactor made up of a plurality of inorganic transparent substrates, each having a surface(s) for bonding, in which the inorganic transparent substrates are bonded together, with the surfaces for bonding in tight contact with each other, to define an inner flow duct for a fluid in the reactor. The method includes polishing the surface(s) for bonding of each of the inorganic transparent substrates and machining a part of an area of the surface(s) for bonding of each of the inorganic transparent substrates to form a groove. The method also includes hydrophilicity enhancing the surface(s) for bonding of each of the inorganic transparent substrates and subsequently allowing the surfaces for bonding to be contacted with water. The method also includes removing water contacted with the surface for bonding following the hydrophilicity enhancing processing under centrifugal force caused by rotation of each of the inorganic transparent substrates. The method also includes causing the surfaces for bonding of the inorganic transparent substrates to adhere to one another to define the flow duct opened to outside the small-sized reactor. The method further includes heating each of the inorganic transparent substrates to a preset bonding temperature to bond the inorganic transparent substrates together.

The present invention also provides a small-sized reactor made up of a plurality of inorganic transparent substrates, layered together, in which each of the inorganic transparent substrates has a surface(s) for bonding to a neighboring one of the inorganic transparent substrates. The small-sized reactor also includes a flow duct made up of a groove formed in the surface for bonding of a first one of the inorganic transparent substrates, a surface for bonding of a second one of the inorganic transparent substrates neighboring to the first inorganic transparent substrate, and a through-hole formed in each of the inorganic transparent substrates. The flow duct opens to outside. The first and second inorganic transparent substrates are unified to each other by the surfaces for bonding chemically bonded to each other.

### Effect of the Invention

The small-sized reactor, produced in accordance with the present invention, has the following merits:
1) Since a small amount of a chemical handled suffices, and the temperature control is facilitated, it is possible to carry out chemical reactions in stability.
2) Since the system is a closed system, high safety may be assured.
3) The yield of a product is high.
4) A mini-plant may be installed in a limited space.
5) Scaling up is facilitated.

Moreover, in the small-sized reactor, produced in accordance with the present invention, the inner state of the reactor may be observed from outside. Hence, if chemical synthesis, for example, is going on, the mixing or the reaction of the chemical drugs flowing in the small-sized reactor may be observed from outside. Consequently, the progress of the reaction process or the reaction of the liquid drugs flowing through the small-sized reactor may be observed. In addition, when a flow duct of the small-sized reactor is stopped up with the liquid drug, the site where the stop-up occurred may be identified to allow for prompt remedying measures.

In addition, since no adhesive is used in the present invention, there is no fear of impurities derived from the adhesive mixing into the reaction system. Furthermore, the reaction may be carried out at elevated temperatures, such as 300°C or higher.

Since the bonding strength is high, the pressure in the reaction flow duct may be as high as 10 atm.

In bonding the inorganic transparent substrates on heating, inner gases may be released to outside, and hence there is no fear of failed bonding or the bonding strength becoming lower due to the elevated internal pressure.

### Brief Description of the Drawings

Figs.1 (a) to (f) are cross-sectional views showing an example production process for a reactor according to the present invention.
Fig.2 is a cross-sectional view for illustrating the process for layering a plurality of inorganic transparent substrates.
Figs.3(a) and (b) are cross-sectional views showing reactors obtained on bonding.
Figs.4(a) to (e) are plan views for illustrating five inorganic transparent substrates to be layered together.
Figs.5(a) to (e) are cross-sectional views for illustrating the five inorganic transparent substrates to be layered together.
Fig.6 is a cross-sectional view for illustrating the layered state of the inorganic transparent substrates.

### Preferred Mode for Carrying out the Invention

### <Example 1>

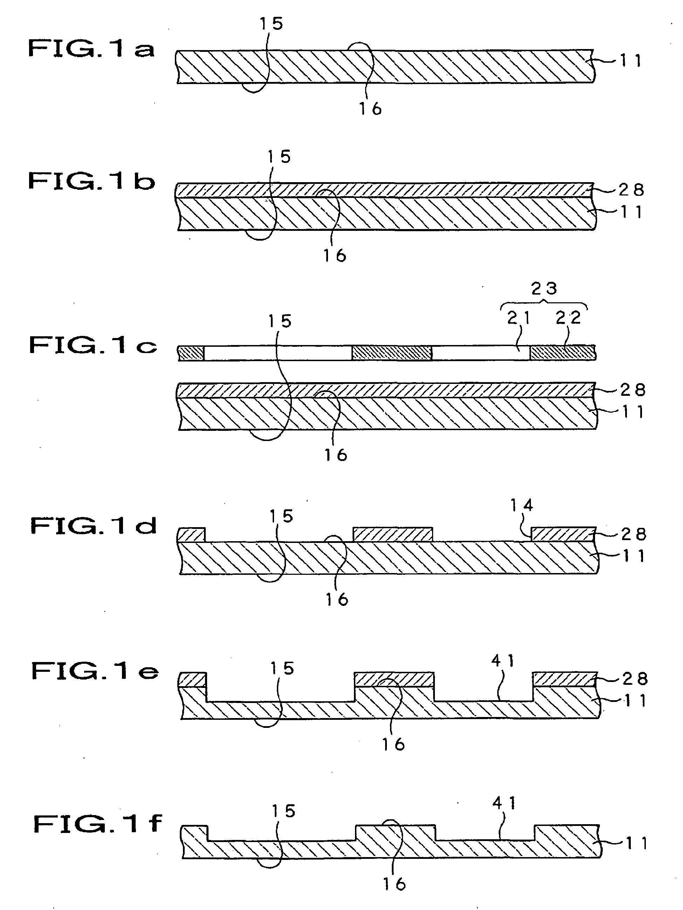

Referring to Figs.1(a) to (f), 2 and 3(a), an Example 1 of the method for producing a small-sized reactor (micro-reactor) according to the present invention will be described.

According to the present invention, a plurality of inorganic transparent substrates is readied, and the following process steps are used to fabricate a small-sized reactor. For each transparent substrate, a transparent glass plate of SiO₂ is used. A surface for bonding of each inorganic transparent substrate, by which the substrate is bonded to another substrate, is processed by the following process steps. The 'glass' used in the present invention includes not only quartz glass composed of SiO₂, but also routine glass sorts mainly composed of SiO₂ and Al₂O₃, and borosilicate glass of SiO₂ containing B₂O₃ in SiO₂.

The respective process steps will now be explained for a case of a first inorganic transparent substrate 11 arranged at the lowermost level.

Initially, a surface for bonding 16 of the first inorganic transparent substrate 11, configured for being bonded to another inorganic transparent substrate, is polished by way of planarizing processing (Fig.1 (a)). It is unnecessary to polish a bottom surface 15 of the first inorganic transparent substrate 11, which is to form the lowermost surface.

For planarizing the surface for bonding 16, a polishing agent, such as cerium oxide, a buff and/or a surfactant, may be used. A liquid drug that modifies the surface properties of an object being polished may also be used in conjunction with the polishing agent.

A resist solution is coated on the planarized surface for bonding 16 of the first inorganic transparent substrate 11 to form a photoresist film 28 (Fig.1 (b))

A photomask 23, having a light transmitting portion 21 and a non-light transmitting portion 22, is arranged on top of the photoresist film 28 (Fig.1 (c)). Exposure light is illuminated on the photomask 23 to permit the exposure light transmitted through the light transmitting portion 21 to arrive at the photoresist film 28.

The photoresist film 28 is photo-reactive, so that a latent image is formed by the exposure light on the photoresist film 28. The photoresist film 28 is developed by a developing solution contacting with the photoresist film 28 on the first inorganic transparent substrate 11. On heating, the photoresist film 28 patterned is formed on the surface for bonding 16 of the first inorganic transparent substrate 11 (Fig.1(d)).

The photoresist film 28 exhibits photo-dissolution performance, so that its portion illuminated by the exposure light is dissolved by the developing solution and removed. The removed portion becomes an opening 14. On the bottom of the opening 14, the surface for bonding 16 has been exposed.

An etching solution is then sprayed over the photoresist film 28 and over the opening 14. Or, the product being processed is introduced into a dry etching device for exposure to etching gas plasma. By so doing, the portion of the first inorganic transparent substrate 11, exposed on the bottom of the opening 14, is etched (Fig.1(e)).

This etching process may also be carried out as the first inorganic transparent substrate 11 is immersed in an etching solution along with the patterned photoresist film 28, provided that a protective film has been formed on the bottom surface 15.

Here, a groove or an opening of a preset depth is formed by etching. According to the present invention, the opening or the groove may be formed not only by wet etching of immersing the product being processed in an etching solution, but also by any of a variety of processing methods, such as dry etching by an etching gas, boring or polishing.

According to the present invention, the 'groove' means not only a bottomed groove but also a non-bottomed groove. Also, the 'groove' means not only a bottomed opening but also a non-bottomed opening.

That is, according to the present invention, a groove 41 formed in the first inorganic transparent substrate 11 is bottomed. However, a non-bottomed groove, viz., a groove that is not bottomed, and extending from the front side through to the bottom side of the first inorganic transparent substrate 11 (through-hole), may also be provided. According to the present invention, etching may be carried out two or more times to provide grooves or openings of differing depths in the same inorganic transparent substrate 11.

The first inorganic transparent substrate 11 is then immersed in a solvent to remove the photoresist film 28, after which the surface for bonding 16 is rinsed with a solvent or a chemical. The solvent is then removed by immersion in a pure water stream. The first inorganic transparent substrate 11 is then set on a base unit of a rotation device, such as a spin coater. The first inorganic transparent substrate 11 is then driven in rotation in a plane parallel to the plane in which the surface for bonding 16 is disposed. This removes pure water affixed to the surface for bonding 16.

At this time, in the first inorganic transparent substrate 11, the surface for bonding 16, externally of the groove 41, is exposed to outside (Fig.1(f)). After drying and desiccation, droplets of a mixed solution of hydrogen peroxide, ammonia and water (with a mixing ratio of 1:1:5) are sprayed onto the surface for bonding 16. The glass surface, contacted with the mixed solution, is possessed of a hydrophilicity, with the contact angle to water becoming smaller.

The so hydrophilicity enhanced first inorganic transparent substrate 11 is then immersed in a pure water stream, by way of rinsing with pure water, such as to remove hydrogen peroxide and ammonia left over on the surface for bonding 16.

In this state, the pure water has formed a film and has become spread over the hydrophilicity enhanced surface for bonding 16. With the pure water film thus spread, the first inorganic transparent substrate 11 is set on the rotary base unit of the rotation device, such as a spin coater. The rotation device is then driven in rotation in a plane parallel to the plane of the surface for bonding 16. By this rotation, the centrifugal force is applied to the pure water film, deposited on the surface for bonding 16, so that the pure water film may be swung off and removed, with the first inorganic transparent substrate 11 remaining unheated.

It is noted that the first inorganic transparent substrate 11 is driven in rotation with the approximately center position of the surface for bonding 16 as the axis of rotation. However, the axis of rotation may also be externally of the first inorganic transparent substrate 11.

In this state, in which the first inorganic transparent substrate 11, carrying the pure water film thereon, has been freed of water on rotation, the pure water film has been removed from the surface for bonding 16. However, adsorbed water molecules are left on the surface for bonding 16.

The inorganic transparent substrate(s), other than the first inorganic transparent substrate 11, composing the small-sized reactor, is planarized and freed of pure water film(s) in the same manner and in the same order as in the case of the first inorganic transparent substrate 11.

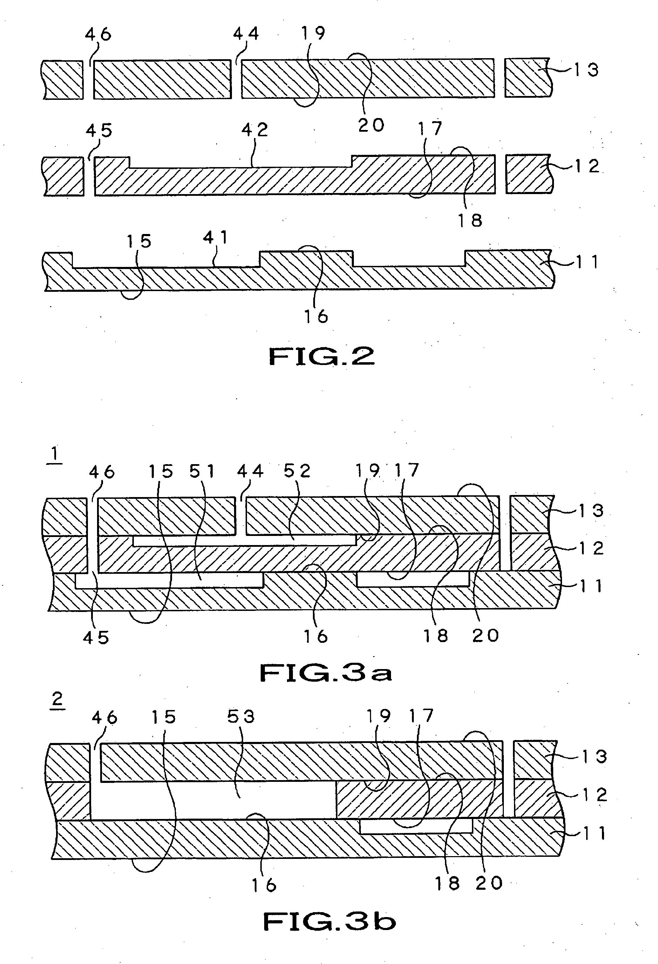

Fig.2 shows a state in which second and third inorganic transparent substrates 12, 13, as the other inorganic transparent substrates, are arranged on top of the surface for bonding 16 of the first inorganic transparent substrate 11.

Both sides of the second inorganic transparent substrate 12 are surfaces for bonding 17, 18, whilst only one side of the third inorganic transparent substrate 13 is a surface for bonding 19. Water molecules remain adsorbed to the surfaces for bonding 16 to 19 of the first to third inorganic transparent substrates 11 to 13. The surfaces for bonding 16, 17 face each other, whilst the surfaces for bonding 18, 19 face each other.

If, in this state, the surfaces for bonding 16 to 19 of the first to third inorganic transparent substrates 11 to 13 are in contact with each other, the first to third inorganic transparent substrates 11 to 13 are bonded together by hydrogen bond with the water molecules present on the contact surfaces.

It is now supposed that, as the first to third inorganic transparent substrates 11 to 13 are bonded to each other at the surfaces for bonding 16 to 19 by hydrogen bond via water molecules, heat treatment is carried out by heating to a temperature in a range from not lower than 500°C to not higher than 1000°C. The hydrogen bond is then changed to chemical bond by oxygen molecules, such that silicon molecules on the surfaces for bonding 16, 17 are unified together, whilst those on the surfaces for bonding 18, 19 are also unified together, by chemical bonding via the oxygen molecules. By this change in the bond types, the first to third inorganic transparent substrates 11 to 13 are bonded to each other more strongly than in case the substrates are bonded by the hydrogen bond, thus yielding the reactor 1 shown in Fig.3(a).

After the first to third inorganic transparent substrates 11 to 13 have been freed of the pure water films by rotation, water molecules are left on the surfaces for bonding 16 to 19 substantially as single layers to undergo a chemical reaction. However, if the pure water films are left over, the relative positions of the first to third inorganic transparent substrates 11 to 13 are shifted, so that no oxygen bond may be formed.

At the time of heating, the major portions of the groove 41, formed in the first inorganic transparent substrate 11, are covered by the surface for bonding 17 of the second inorganic transparent substrate 12. In similar manner, the major portions of the groove 42, formed in the second inorganic transparent substrate 12, are covered by the surface for bonding 19 of the third inorganic transparent substrate 13. As a result, flow ducts 51, 52, the liquid drug flows through, are formed by the grooves 41, 42 and the contact surfaces 17, 19, as shown in Fig.3(a).

These flow ducts 51, 52 communicate with outside of the reactor 1 by through-holes 44 to 46 formed in the inorganic transparent substrates 11 to 13.

The first to third inorganic transparent substrates 11 to 13, layered or stacked together, are connected to outside via through-holes 44 to 46 and thus opened to the outside. In this state, the first to third inorganic transparent substrates 11 to 13 are heated and bonded together. Thus, at the time of heating, there is formed no occluded spacing between any two of the first to third inorganic transparent substrates 11 to 13, should any gas, here air, present in the space, the liquid drug flows through, be heated and thereby expanded, the gas is released to outside via the through-holes 44 to 46.

It is noted that, in the above Example, the flow ducts 51, 52 are formed by the bottomed grooves 41, 42 and the contact surfaces 17, 19. However, a flow duct 53 may be formed by covering all or part of the front and back sides of a through-hole of a broader width by contact surfaces 16, 19, as in the case of the reactor 2 of Fig.3(b).

It has become known that, if the surfaces for bonding are planarized so that the centerline average roughness Ra of the surfaces for bonding is not greater than 2 nm, the number of non-contact portions that may produce a gap when the surfaces for bonding are contacted with each other is appreciably smaller than in case the centerline average roughness Ra is greater than 2 nm. According to the present invention, the inorganic transparent substrate is planarized by polishing so that the centerline average roughness Ra of the surfaces for bonding is not greater than 2 nm.

### <Bonding Test>

A test on bonding the inorganic transparent substrates together will now be explained. In an Example of the present invention, surfaces for bonding of six inorganic transparent substrates of quartz glass are processed by planarizing processing by polishing, hydrophilicity enhancing processing, rinsing processing by pure water and by processing of removing a pure water film on rotation, in this order. In the hydrophilicity enhancing processing, the surfaces for bonding are contacted with a mixed solution of hydrogen peroxide, ammonia and water at a mixing ratio of 1:1:5. With water molecules remaining adsorbed to the surfaces for bonding of the inorganic transparent substrates, the surfaces for bonding are contacted with each other and the inorganic transparent substrates are layered or stacked together in this state. The resulting assembly was heated to 590°C for chemical bonding/ adhesion.

In the six inorganic transparent substrates, there are five layers of bonded surfaces, each of which is formed by two surfaces for bonding connected together. These bonded surfaces may be observed from above the six inorganic transparent substrates.

If, after the bonding, the respective bonded surfaces are observed, the portion that failed to undergo chemical bonding may be distinguished from the portion that underwent the chemical bonding. The total area of the bonded surfaces of the five layers is denoted as 'bonded area'. The area recognized to have failed to undergo chemical bonding in each of the five layers of the bonded surfaces is denoted as 'non-bonded area'. In the following Table 1, the bonded surfaces are numbered, and measured values of the non-bonded areas are entered in the column 'Example'.

In a Comparative Example, processing is different from that of the case of the above Example. That is, the planarizing processing by polishing and the hydrophilicity enhancing processing, in which the surfaces for bonding are contacted with a mixed solution of hydrogen peroxide, ammonia and water at a mixing ratio of 1:1:5, were first carried out. However, the rinsing with pure water and processing by rotation were not carried out. After drying on heating, the inorganic transparent substrates were layered together with the surfaces for bonding thereof in contact with each other. The resulting assembly was heated to the same temperature as in the above Example. Measured values of the bonded areas and the non-bonded areas are entered in the column (Comparative Example) in the Table.

**Table 1**

| | Comparative Example | Example |
|---|---|---|
| Bonded area (cm²) | 138.9 | 138.9 |
| Non-bonded area-1 | 0.2 | 0.3 |
| Non-bonded area-2 | 0.5 | 0.03 |
| Non-bonded area-3 | 0.03 | 0.0 |
| Non-bonded area-4 | 0.03 | 0.0 |
| Non-bonded area-5 | 0.03 | 0.0 |
| Sum total of non-bonded areas | 0.8 | 0.3 |

It is seen that the sum total of the non-bonded areas of the Example is not greater than one-half of the corresponding value of the Comparative Example such that bonding has been positively achieved in the Example.

Surface planarity of the inorganic transparent substrates used in each of the 'Example' and in the 'Comparative Example' was measured. The centerline average roughness of the planarized surface for bonding Ra was 0.5 to 0.7 nm, which is an average value of measured values at a plurality of sites for measurement. A measured length L per site for measurement L is 10 µm. It is seen that, with the centerline average roughness Ra not greater than 2 nm, the inorganic transparent substrates may be bonded together.

### <Another Example>

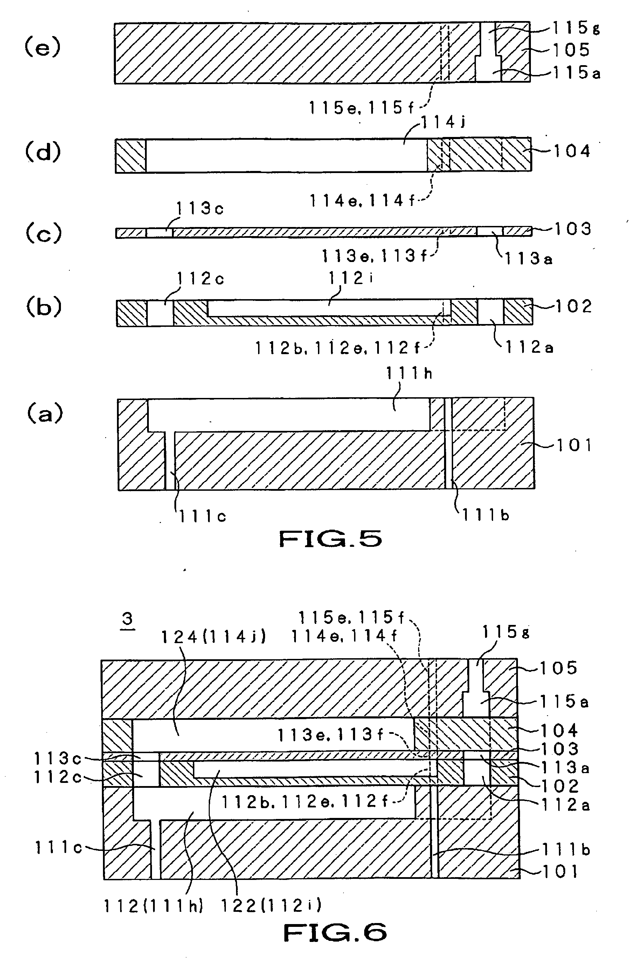

Fig.6 shows a reactor 3 of another Example of the present invention.

In the preset reactor 3, the surfaces for bonding of the five inorganic transparent substrates 101 to 105 of boroslicate glass are processed by the same process as that of the above Example 1. That is, the five inorganic transparent substrates 101 to 105 are initially planarized by polishing. Bottomed or non-bottomed grooves (through-holes) are then formed by etching by way of groove forming in the inorganic transparent substrates. Then, the processing of hydrophilicity enhancing the surfaces for bonding by aqueous hydrogen peroxide, rinsing by pure water and removal of a pure water film on rotation, are then carried out in this order.

With water molecules remaining adsorbed to the surfaces for bonding, the inorganic transparent substrates 101 to 105 were layered together as their contact surfaces were contacted with each other. The resulting assembly was heated to 570°C for chemical bonding/ adhesion.

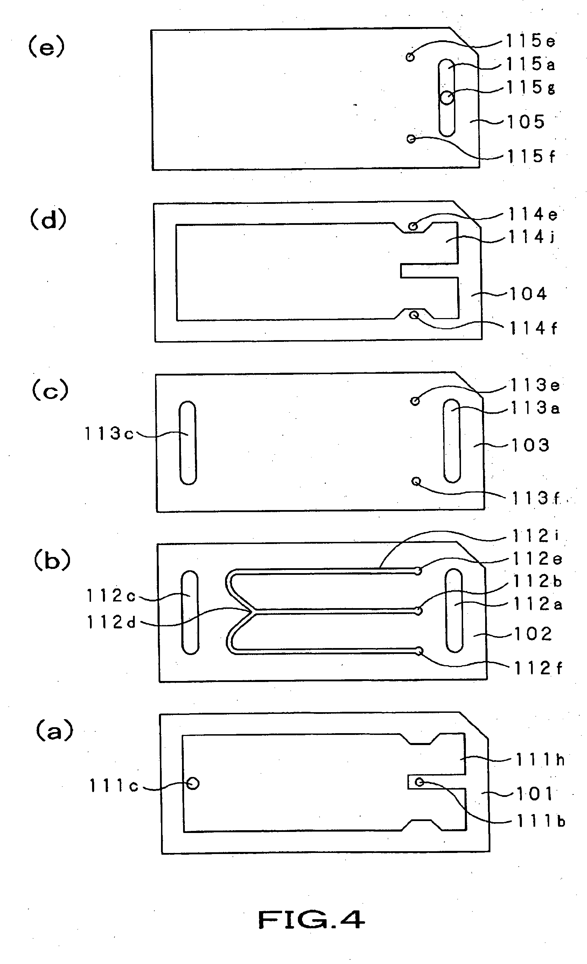

The first to fifth inorganic transparent substrates 101 to 105 were layered together to form a small-sized reactor 3. Both sides of the second to fourth inorganic transparent substrates are surfaces for bonding and only one side of each of the first and fifth inorganic transparent substrates is a surface for bonding. Figs.4(a) to (e) are plan views showing the first to fifth inorganic transparent substrates 101 to 105 arranged in the layering order with position matching along the longitudinal direction. Figs.5(a) to (e) are side views showing the first to fifth inorganic transparent substrates 101 to 105 arranged in the layering order with position matching along the longitudinal direction.

The first inorganic transparent substrate 101 includes a lower water reservoir groove 111h, a heat medium inlet 111 c and a first liquid drug outlet 111 b. The lower water reservoir groove is bottomed and broader in width for use for temperature management, and the heat medium inlet 111 c is formed in the bottom surface of the lower water reservoir groove 111h and used for opening the inside to outside. The first liquid drug outlet is a through-hole formed at a position distinct from the lower water reservoir groove 111h.

The second inorganic transparent substrate 102, arranged on top of the first inorganic transparent substrate 101, includes a bottomed elongated narrow-width groove 112i, positioned on top of the lower water reservoir groove 111 h. The lower water reservoir groove 111h is covered by the bottom of the narrow-width groove 112i to construct a lower jacket indicated by a reference numeral 121 in Fig.6.

The second inorganic transparent substrate 102 also includes communication openings 112a, 112c on top of both extreme positions of the lower water reservoir groove 111h of the first inorganic transparent substrate 101. These communication openings 112a, 112c are through-holes used for water to pass through and connect to the inside of the lower jacket 121.

The narrow-width groove 112i has a confluent point 112d from which the groove is branched in three directions. One branched end is located at a position to communicate with the first liquid drug outlet 111b of the first inorganic transparent substrate 101 when the inorganic transparent substrates are layered together. The branched end includes a second outlet 112b, which is also a through-hole.

The other two branched ends of the narrow-width groove 112i include liquid drug inlets 112e, 112f broader in width than the narrow-width groove 112i.

The third inorganic transparent substrate 103 includes a flow duct for reaction 122 that covers up the narrow-width groove 112i when the third inorganic transparent substrate is set in the layered position.

The third inorganic transparent substrate 103 includes communication openings 113a, 113c which are through-holes for water to pass through. These communication openings 113a, 113c are formed at the positions of communicating with the two communication openings 112a, 112c of the second inorganic transparent substrate 102. The third inorganic transparent substrate 103 includes liquid drug outlets 113e, 113fwhich are through-holes. The liquid drug outlets 113e, 113f are disposed on top of and connected to the liquid drug inlets 112e, 112f of the second inorganic transparent substrate 102.

In the fourth inorganic transparent substrate 104, there is formed a non-bottomed upper water reservoir groove 114j of a broader width used for temperature management. Outside the upper water reservoir groove 114j, there are formed liquid drug outlets 114e, 114f, which are through-holes.

When in a connected position, the upper water reservoir groove 114j is connected to communication openings 112c, 113c, disposed on top of the heat medium inlet 111c, and has its opposite end in communication with the communication openings 112a, 113a located on the opposite side of the heat medium inlet 111c.

Hence, the lower water reservoir groove 111h and the upper water reservoir groove 114j are connected on both ends by the communication openings 112a, 112c, 113a, 113c bored in the second and third inorganic transparent substrates 102, 103, respectively.

When the inorganic transparent substrates are layered in position, an upper water reservoir groove 114e is covered up by the bonded surface of the fifth inorganic transparent substrate 105, thus forming an upper jacket indicated by reference numeral 124 of Fig.6.

In the surface for bonding of the fifth inorganic transparent substrate 105, bonded to the fourth inorganic transparent substrate 104, there is bored an outlet groove 115a. In the bottom surface of the outlet groove 115a, there is bored a heat medium outlet 115g which is a through-hole.

The outlet groove 115a is formed on top of one of the ends of the upper water reservoir groove 114j of the fourth inorganic transparent substrate 104 which is on an opposite side with respect to the heat medium inlet 111c of the first inorganic transparent substrate 101. The outlet groove is thus in communication with the upper water reservoir groove 114j. The upper jacket 124 communicates with outside via the outlet groove 115a and the heat medium outlet 115g.

Liquid drug inlets 115e, 115f are formed in the fifth inorganic transparent substrate 105 on top of two liquid drug inlets 114e, 114f formed in the fourth inorganic transparent substrate 104. The liquid drug inlets 115e, 115f, formed in the fifth inorganic transparent substrate 105, the liquid drug inlets 114e, 114f, formed in the fourth inorganic transparent substrate 104, and the liquid drug inlets 113e, 113f, formed in the third inorganic transparent substrate103, are in communication with one another to define two flow ducts in the layering direction.

These two flow ducts in the layering direction communicate with two flow ducts that are unified into a single flow duct via the liquid drug inlets 112e, 112f at the confluent point 112d. The liquid drug, introduced into the above mentioned flow ducts in the layering direction, will flow in confluence at the single confluent point 112d in the flow duct 122 to flow in the single flow duct so as to flow to outside of the reactor 103 via the second outlet 112b at the liquid drug outlet 111b.

Thus, if two liquid drugs, which react with each other, are introduced into the small-sized reactor 3 via the two liquid drug inlets 115e, 115f in the fifth inorganic transparent substrate 105, the liquid drugs flow in confluence at the single confluent point 112d of the flow duct 122. The two liquid drugs are thus mixed together to initiate the reaction. The liquid drugs continue to flow in the single flow duct 122, during which time the reaction proceeds. Reaction products may be taken out via the liquid drug outlet 111b.

At this time, the temperature management medium, such as hot water or cold water, controlled in its temperature, is introduced via the heat medium inlet 111c in the reactor 3 so that the lower jacket 121 is filled with the temperature management medium. This temperature management medium is discharged to outside via the heat medium outlet 115g at the communication openings 112a, 113a and at the outlet groove 115a. The communication openings 112a, 113a are disposed at an opposite end to the heat medium inlet 111c. The heat management medium, introduced at the heat medium inlet 111c, is introduced into the upper jacket 124 via the communication openings 112c, 113c disposed on top of the heat medium inlet 111c. The liquid drug, which has filled the upper jacket 124, is discharged to outside via the outlet groove 115a and the heat medium outlet 115g. Thus, in the reactor 3, the flow duct 122 is sandwiched between the temperature management mediums charged into the lower jacket 121 and the upper jacket 124. Thus, by managing the temperature of the liquid drugs in the flow duct 122 in a desired manner, the liquid drugs in the flow duct 122 may be maintained at a desired temperature. Hence, with the reactor 3, the liquid drugs flowing in the flow duct 122 may be heated and cooled at a high efficiency.

It is now supposed that, in forming the small-sized reactor 3, the inorganic transparent substrates 101 to 105, layered together, are heated and bonded together. In such case, the inner grooves, inclusive of openings, are opened to outside the small-sized reactor 3 via the through-holes 111c,111b, 115e, 115f and 115g, inclusive of non-bottomed grooves, formed in the lowermost or uppermost inorganic transparent substrates 101, 105. Thus, in the present small-sized reactor 3, no occluded spacing is formed, such that, if a gas (herein air) present in the flow duct 122, lower jacket 121 or the upper jacket 124, where the liquid, such as liquid drugs or the heat medium, is expanded, the expanded gas is discharged to outside via the through-holes 111c, 111b, 115e, 115f and 115g.

Although the temperature management medium flows from below towards above in the reactor 3, it may also flow from above towards below. The two liquid drugs may also flow from below towards above so as to flow in confluence at the confluent point before flowing towards above.

In the above Example, the total of the surfaces for bonding has part of its surface etched. However, there may exist a surface for bonding which is not etched.

Moreover, two different liquid drugs are configured to flow in confluence to undergo a chemical reaction in the flow duct 122. The small-sized reactors 1 to 3 are not limited to this configuration such that a single liquid drug may be heated or cooled to control the reaction as it flows in the flow duct 122.

According to the present invention, the 'flow duct' may mean not only the parts denoted by the reference numerals 51, 52 and 122, the liquid drugs flow through, but also the portions in the small-sized reactors 1 to 3 where the fluid supplied from outside is allowed to flow. These portions may include vertically extending liquid drug inlets 115e, 115f to allow the liquid drugs to flow vertically, the upper jackets 121, 124 and the heat medium inlet 111c, as well as those portions inside the small-sized reactors 1 to 3 where the fluid supplied from outside is allowed to flow.

## Claims

1. A method for producing a small-sized reactor (3) made up of a plurality of inorganic transparent substrates (11, 12, 13) each having a surface(s) for bonding (16, 17, 18, 19); the inorganic transparent substrates (11, 12, 13) being bonded together, with the surfaces for bonding (16, 17, 18, 19) in tight contact with each other, to define an inner flow duct (51, 52) for a fluid therein, the method comprising:
polishing the surfaces for bonding (16, 17, 18, 19) of each of the inorganic transparent substrates (11, 12, 13) so that a centerline average roughness Ra will be not greater than 2 nm, and subsequently machining a part of an area of the surfaces for bonding (16, 17, 18, 19) of the inorganic transparent substrates (11, 12, 13) to form a groove (41, 42);
hydrophilicity enhancing the surfaces for bonding (16, 17, 18, 19) of the inorganic transparent substrates (11, 12, 13) and subsequently allowing the surfaces for bonding (16, 17, 18, 19) to be contacted with water;
removing water contacted with the surfaces for bonding (16, 17, 18, 19) following the hydrophilicity enhancing processing under centrifugal force caused by rotation of each of the inorganic transparent substrates (11, 12, 13); and
heating, as the surfaces for bonding (16, 17, 18, 19) of the inorganic transparent substrates (11, 12, 13) are contacted with one another, each of the inorganic transparent substrates (11, 12, 13) to a preset bonding temperature to bond the inorganic transparent substrates (11, 12, 13) to one another.

2. The method for producing the small-sized reactor(3) according to claim 1, wherein
each of the inorganic transparent substrates (11, 12, 13) is formed of glass; the temperature of the heating being not less than 500°C and not higher than 1000°C.

3. The method for producing the small-sized reactor (3) according to claim 2, wherein
the inside of the flow duct (51, 52) is heated to the temperature for heating as the inside of the flow duct (51, 52) is exposed to outside the small-sized reactor (3).

4. The method for producing the small-sized reactor (3) according to any one of claims 1 to 3, wherein
the hydrophilicity enhancing processing is carried out as each of the surfaces for bonding (16, 17, 18, 19) is contacted with a hydrophilicity enhancing solution containing aqueous hydrogen peroxide and ammonia.

5. A method for producing a small-sized reactor (3) made up of a plurality of inorganic transparent substrates (11, 12, 13) each having a surface(s) for bonding (16, 17, 18, 19); the inorganic transparent substrates (11, 12, 13) being bonded together, with the surfaces for bonding (16, 17, 18, 19) in tight contact with each other, to define an inner flow duct (51, 52) for a fluid in the reactor, the method comprising:
polishing the surfaces for bonding (16, 17, 18, 19) of each of the inorganic transparent substrates (11, 12, 13) and subsequently machining a part of an area of the surface(s) for bonding (16, 17, 18, 19) of each of the inorganic transparent substrates (11, 12, 13) to form a groove (41, 42);
hydrophilicity enhancing the surfaces for bonding (16, 17, 18, 19) of each of the inorganic transparent substrates (11, 12, 13) and subsequently allowing the surfaces for bonding (16, 17, 18, 19) to be contacted with water;
removing water contacted with the surface for bonding (16, 17, 18, 19) following the hydrophilicity enhancing processing under centrifugal force caused by rotation of the inorganic transparent substrates (11, 12, 13);
causing the surfaces for bonding (16, 17, 18, 19) of the inorganic transparent substrates (11, 12, 13) to bonded to one another to define the flow duct (51, 52) opened to outside the small-sized reactor (3); and
heating each of the inorganic transparent substrates (11, 12, 13) to a preset bonding temperature to bond the inorganic transparent substrates (11, 12, 13) together.

## Patentansprüche

1. Verfahren zur Herstellung eines kleinflächigen Reaktors (3), der aus einer Mehrzahl von anorganischen transparenten Substraten (11, 12, 13) ausgebildet ist, die jeweils eine Oberfläche/Oberflächen zum Bonden (16, 17, 18, 19) aufweisen, wobei die anorganischen transparenten Substrate (11, 12, 13) derart aneinander gebondet werden, dass ihre Oberflächen zum Bonden (16, 17, 18, 19) in engem Kontakt zueinander stehen, um einen inneren Strömungsdurchgang (51, 52) für eine sich darin befindliche Flüssigkeit zu definieren, wobei das Verfahren aufweist:
Polieren der Oberflächen zum Bonden (16, 17, 18, 19) jedes der anorganischen transparenten Substrate (11, 12, 13) derart, dass eine durchschnittliche Rauigkeit Ra entlang einer Mittellinie nicht größer als 2 nm ist, und daraufhin Bearbeiten eines Teils eines Bereichs der Oberflächen zum Bonden (16, 17, 18, 19) der anorganischen transparenten Substrate (11, 12, 13), um eine Vertiefung (41, 42) auszubilden;
Erhöhen der Hydrophilie der Oberflächen zum Bonden (16, 17, 18, 19) der anorganischen transparenten Substrate (11, 12, 13) und daraufhin Zulassen, dass die Oberflächen zum Bonden (16, 17, 18, 19) mit Wasser kontaktiert werden;
Entfernen des Wassers, das nach dem Bearbeiten zur Erhöhung der Hydrophilie mit den Oberflächen zum Bonden (16, 17, 18, 19) in Kontakt steht, unter Verwendung einer Zentrifugalkraft, die durch die Rotation von jedem der anorganischen transparenten Substrate (11, 12, 13) erzeugt wird; und
Heizen jedes der anorganischen transparenten Substrate (11, 12, 13) auf eine voreingestellte Bondtemperatur, während die Oberflächen zum Bonden (16, 17, 18, 19) der anorganischen transparenten Substrate (11, 12, 13) miteinander in Verbindung gebracht werden, um die anorganischen transparenten Substrate (11, 12, 13) aneinander zu bonden.

2. Verfahren zur Herstellung des kleinflächigen Reaktors (3) gemäß Anspruch 1, wobei
jedes der anorganischen transparenten Substrate (11, 12, 13) aus Glas ausgebildet ist, wobei die Temperatur des Heizens nicht weniger als 500°C und nicht mehr als 1000°C beträgt.

3. Verfahren zur Herstellung des kleinflächigen Reaktors (3) gemäß Anspruch 2, wobei
die Innenseite des Strömungsdurchgangs (51, 52) auf die Temperatur zum Heizen aufgeheizt wird, während die Innenseite des Strömungsdurchgangs (51, 52) auf der Außenseite des kleinflächigen Reaktors (3) liegt.

4. Verfahren zur Herstellung des kleinflächigen Reaktors (3) gemäß einem der Ansprüche 1 bis 3, wobei
die Bearbeitung zur Erhöhung der Hydrophilie ausgeführt wird, während jede der Oberflächen zum Bonden (16, 17, 18, 19) in Kontakt mit einer Hydrophilie erhöhenden Lösung steht, die wässriges Wasserstoffperoxid und Ammoniak enthält.

5. Verfahren zur Herstellung eines kleinflächigen Reaktors (3), der aus einer Mehrzahl von anorganischen transparenten Substraten (11, 12, 13) ausgebildet ist, die jeweils eine Oberfläche/Oberflächen zum Bonden (16, 17, 18, 19) aufweisen, wobei die anorganischen transparenten Substrate (11, 12, 13) derart aneinander gebondet werden, dass die Oberflächen zum Bonden (16, 17, 18, 19) in engen Kontakt zueinander stehen, um einen inneren Strömungsdurchgang (51, 52) für eine Flüssigkeit in dem Reaktor zu definieren, wobei das Verfahren aufweist:
Polieren der Oberflächen zum Bonden (16, 17, 18, 19) jedes der anorganischen transparenten Substrate (11, 12, 13) und daraufhin Bearbeiten eines Teils eines Bereichs der Oberfläche(n) zum Bonden (16, 17, 18, 19) jedes der anorganischen transparenten Substrate (11, 12, 13), um eine Vertiefung (41, 42) auszubilden;
Erhöhen der Hydrophilie der Oberflächen zum Bonden (16, 17, 18, 19) jedes der anorganischen transparenten Substrate (11, 12, 13) und daraufhin Zulassen, dass die Oberflächen zum Bonden (16, 17, 18, 19) mit Wasser kontaktiert werden;
Entfernen des Wassers, das nach dem Bearbeiten zum Erhöhen der Hydrophilie mit der Oberflächen zum Bonden (16, 17, 18, 19) in Kontakt steht, unter Verwendung einer Zentrifugalkraft, die durch die Rotation der anorganischen transparenten Substrate (11, 12, 13) erzeugt wird;
Bewirken des Bondens der Oberflächen zum Bonden (16, 17, 18, 19) der anorganischen transparenten Substrate (11, 12, 13) aneinander, um den Strömungsdurchgang (51, 52) zu definieren, der zu einer Außenseite des kleinflächigen Reaktors (3) hin offen ist; und
Heizen jedes der anorganischen transparenten Substrate (11, 12, 13) auf eine voreingestellte Bondtemperatur, um die anorganischen transparenten Substrate (11, 12, 13) aneinander zu bonden.

## Revendications

1. Procédé pour produire un réacteur de petite taille (3) composé de plusieurs substrats transparents inorganiques (11, 12, 13) qui présentent chacun une ou plusieurs surfaces de liaison (16, 17, 18, 19) ; les substrats transparents inorganiques (11, 12, 13) étant reliés, avec les surfaces de liaison (16, 17, 18, 19) en contact étroit entre elles, pour définir un conduit d'écoulement intérieur (51, 52) pour un fluide, le procédé comprenant les étapes qui consistent :
à polir les surfaces de liaison (16, 17, 18, 19) de chacun des substrats transparents inorganiques (11, 12, 13) de telle sorte qu'une rugosité moyenne arithmétique Ra ne soit pas supérieure à 2 nm, et à usiner ensuite une partie d'une superficie des surfaces de liaison (16, 17, 18, 19) des substrats transparents inorganiques (11, 12, 13) pour former une rainure (41, 42) ;
à augmenter l'hydrophilie des surfaces de liaison (16, 17, 18, 19) des substrats transparents inorganiques (11, 12, 13) et à permettre ensuite aux surfaces de liaison (16, 17, 18, 19) d'être en contact avec de l'eau ;
à enlever l'eau en contact avec les surfaces de liaison (16, 17, 18, 19) à la suite du traitement d'augmentation d'hydrophilie, sous l'action d'une force centrifuge provoquée par la rotation de chacun des substrats transparents inorganiques (11, 12, 13) ; et
à chauffer, alors que les surfaces de liaison (16, 17, 17, 18, 19) des substrats transparents inorganiques (11, 12, 13) sont en contact entre elles, chacun desdits substrats transparents inorganiques (11, 12, 13) à une température de liaison prédéfinie, pour relier les substrats transparents inorganiques (11, 12, 13) entre eux.

2. Procédé pour produire le réacteur de petite taille (3) selon la revendication 1, étant précisé que chacun des substrats transparents inorganiques (11, 12, 13) est en verre ; la température de chauffe n'étant pas inférieure à 500°C et pas supérieure à 1000°C.

3. Procédé pour produire le réacteur de petite taille (3) selon la revendication 2, étant précisé que l'intérieur du conduit d'écoulement (51, 52) est chauffé à la température de chauffe en étant exposé à l'extérieur du réacteur de petite taille (3).

4. Procédé pour produire le réacteur de petite taille (3) selon l'une quelconque des revendications 1 à 3, étant précisé que le traitement d'augmentation d'hydrophilie est réalisé alors que chacune des surfaces de liaison (16, 17, 18, 19) est en contact avec une solution d'augmentation d'hydrophilie contenant du peroxyde d'hydrogène aqueux et de l'ammoniac.

5. Procédé pour produire un réacteur de petite taille (3) composé de plusieurs substrats transparents inorganiques (11, 12, 13) qui présentent chacun une ou plusieurs surfaces de liaison (16, 17, 18, 19) ; les substrats transparents inorganiques (11, 12, 13) étant reliés, avec les surfaces de liaison (16, 17, 18, 19) en contact étroit entre elles, pour définir un conduit d'écoulement intérieur (51, 52) pour un fluide, le procédé comprenant les étapes qui consistent :
à polir les surfaces de liaison (16, 17, 18, 19) de chacun des substrats transparents inorganiques (11, 12, 13), et à usiner ensuite une partie d'une superficie de la ou des surfaces de liaison (16, 17, 18, 19) de chacun des substrats transparents inorganiques (11, 12, 13) pour former une rainure (41, 42) ;
à augmenter l'hydrophilie des surfaces de liaison (16, 17, 18, 19) de chacun des substrats transparents inorganiques (11, 12, 13) et à permettre ensuite aux surfaces de liaison (16, 17, 18, 19) d'être en contact avec de l'eau ;
à enlever l'eau en contact avec les surfaces de liaison (16, 17, 18, 19) à la suite du traitement d'augmentation d'hydrophilie, sous l'action d'une force centrifuge provoquée par la rotation des substrats transparents inorganiques (11, 12, 13) ;
à amener les surfaces de liaison (16, 17, 18, 19) des substrats transparents inorganiques (11, 12, 13) à être reliées entre elles pour définir le conduit (51, 52) ouvert sur l'extérieur du réacteur de petite taille (3) ; et
à chauffer chacun des substrats transparents inorganiques (11, 12, 13) à une température de liaison prédéfinie, pour relier lesdits substrats transparents inorganiques (11, 12, 13) entre eux.
